(19) Europäisches Patentamt
European Patent Office
Office européen des brevets

(11) **EP 3 370 077 B1**

(12) **FASCICULE DE BREVET EUROPEEN**

(45) Date de publication et mention
de la délivrance du brevet:
**31.07.2019 Bulletin 2019/31**

(51) Int Cl.:
***G01R 33/26*** *(2006.01)*

(21) Numéro de dépôt: **18158756.9**

(22) Date de dépôt: **27.02.2018**

(54) **MAGNÉTOMÈTRE À POMPAGE OPTIQUE ISOTROPE**

MAGNETOMETER MIT ISOTROPER OPTISCHER PUMPFUNKTION

MAGNETOMETER WITH ISOTROPIC OPTICAL PUMPING

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **01.03.2017 FR 1751672**

(43) Date de publication de la demande:
**05.09.2018 Bulletin 2018/36**

(73) Titulaire: **Commissariat à l'énergie atomique
et aux énergies alternatives
75015 Paris (FR)**

(72) Inventeurs:
• **JAGER, Thomas
38000 GRENOBLE (FR)**
• **BERTRAND, François
38180 SEYSSINS (FR)**

(74) Mandataire: **Brevalex
95, rue d'Amsterdam
75378 Paris Cedex 8 (FR)**

(56) Documents cités:
**FR-A1- 2 984 519**

• **GAUTHIER HULOT ET AL: "Swarm 's absolute magnetometer experimental vector mode, an innovative capability for space magnetometry", GEOPHYSICAL RESEARCH LETTERS, vol. 42, no. 5, 4 mars 2015 (2015-03-04), pages 1352-1359, XP055444253, United States ISSN: 0094-8276, DOI: 10.1002/2014GL062700**
• **JEAN-MICHEL LÉGER ET AL: "In-flight performance of the Absolute Scalar Magnetometer vector mode on board the Swarm satellites", EARTH, PLANETS AND SPACE, vol. 67, no. 1, 25 avril 2015 (2015-04-25), XP055444255, DOI: 10.1186/s40623-015-0231-1**
• **WU T ET AL: "A dead-zone free4He atomic magnetometer with intensity-modulated linearly polarized light and a liquid crystal polarization rotator", REVIEW OF SCIENTIFIC INSTRUMENTS, AIP, MELVILLE, NY, US, vol. 86, no. 10, 13 octobre 2015 (2015-10-13), XP012201279, ISSN: 0034-6748, DOI: 10.1063/1.4932528 [extrait le 1901-01-01]**

## Description

## DOMAINE TECHNIQUE

Le domaine de l'invention est celui des magnétomètres scalaires à pompage optique présentant des caractéristiques anisotropes en ce sens que l'amplitude des signaux de résonance magnétique utilisés pour mesurer le champ magnétique ambiant $\vec{B}$ dépend des orientations relatives entre l'axe de propagation $\vec{k}$ du faisceau du laser pompe, la direction du champ magnétique ambiant $\vec{B}$, l'orientation de la polarisation du faisceau laser pompe $\vec{E}$ et également l'orientation d'un champ RF $\overrightarrow{B_{RF}}$ quand ce principe d'excitation de la résonance magnétique est choisi dans la mise en oeuvre instrumentale.

Dans ce cadre, l'invention concerne conjointement le pilotage de l'orientation $\theta_{pol}$ de la polarisation $\vec{E}$ dans le plan orthogonal à la direction de propagation du faisceau optique $\vec{k}$, le pilotage de l'orientation $\theta_{RF}$ dans ce même plan orthogonal du champ $\overrightarrow{B_{RF}}$ d'excitation de la résonance magnétique lorsque celui-ci est utilisé, et la gestion de zones d'indétermination dans le pilotage de ces orientations relatives. La mise en oeuvre combinée de ces différents éléments permet de réaliser un magnétomètre isotrope quelle que soit l'orientation du champ magnétique ambiant $\vec{B}$ dans le repère du magnétomètre. L'invention s'avère notamment avantageuse pour des magnétomètres embarqués, par exemple dans des applications spatiales ou/et aéroportées.

## ÉTAT DE LA TECHNIQUE ANTÉRIEURE

Un magnétomètre à pompage optique est qualifié d'isotrope lorsque les conditions de la détection de la résonance ne dépendent pas de l'orientation relative du magnétomètre par rapport au champ magnétique ambiant $\vec{B}$.

Pour assurer un fonctionnement isotrope, il est nécessaire de piloter l'orientation de la polarisation du faisceau pompe $\vec{E}$ par rapport à la direction du champ magnétique ambiant $\vec{B}$ ainsi que de piloter l'orientation du champ RF $\overrightarrow{B_{RF}}$ quand ce principe d'excitation de la résonance magnétique est choisi dans la mise en oeuvre instrumentale. De tels pilotages peuvent être réalisés à l'aide d'un ensemble {rotor + polariseur + bobines RF + moteur} dans une structure de magnétomètre bi-bloc comprenant un rotor et un stator, ou à l'aide d'éléments tels qu'un rotateur de polarisation à cristal liquide couplé à plusieurs jeux de bobines RF dans une structure de magnétomètre monobloc ne comprenant aucun élément mobile. On trouvera un exemple de cette dernière structure dans le brevet EP 2 795 354 B1.

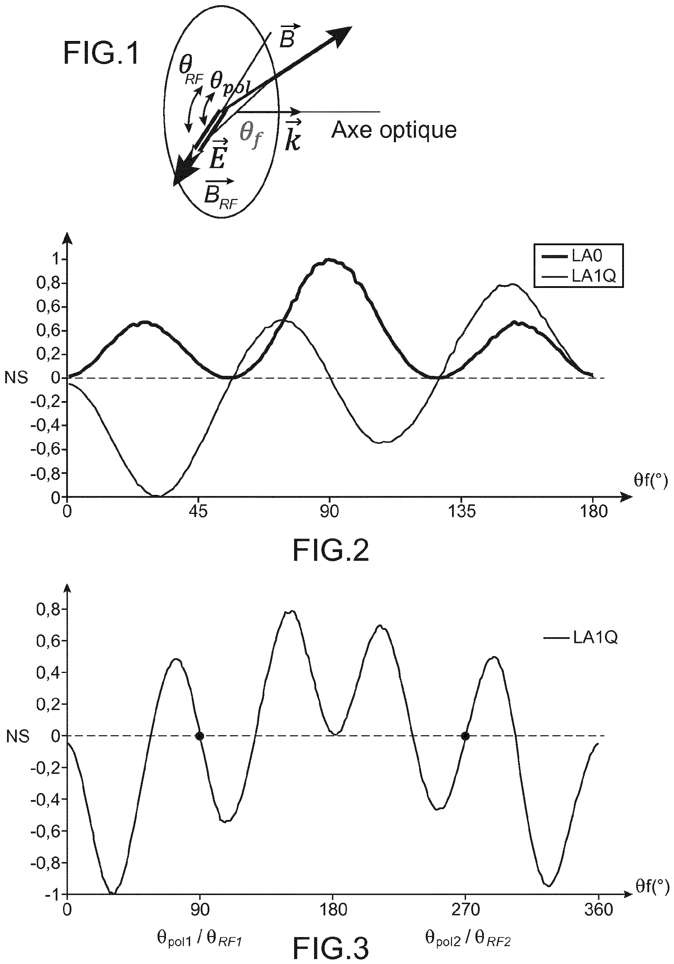

Plus particulièrement, le fonctionnement isotrope du magnétomètre est classiquement obtenu en asservissant à la fois l'orientation relative $\theta_f$ entre $\vec{E}$ et $\vec{B}$ à un angle constant de 90 ° et l'orientation relative entre $\overrightarrow{B_{RF}}$ et $\vec{B}$ et à un angle constant de 90° également (dans ce cas $\vec{E}$ et $\overrightarrow{B_{RF}}$ sont alignés). On fait pour cela tourner l'angle $\theta_{pol}$ de la polarisation $\vec{E}$ et l'angle $\theta_{RF}$ du champ RF $\overrightarrow{B_{RF}}$ dans le plan orthogonal au trajet optique, comme cela est représenté sur la figure 1 pour le cas particulier d'un magnétomètre dont la résonance est excitée par un signal RF.

La position $\theta_f = 90°$ permet de maximiser le signal de résonance magnétique utilisé pour la mesure de champ magnétique, typiquement le signal de résonance « LA0 » ou « LA2 » (respectivement la composante continue du signal de résonance à la fréquence de Larmor, et la composante à une fréquence double de la fréquence de Larmor de ce signal). Comme cela est détaillé sur la figure 2 pour le cas du signal LA0 (en trait épais), le niveau de signal NS (unité arbitraire) est effectivement maximal pour $\theta_f = 90°$. L'asservissement de $\theta_f$ à 90° par le pilotage de l'angle de la polarisation $\theta_{pol}$ est réalisé en utilisant le signal de résonance magnétique « LA1Q » (en trait fin sur la figure 2) comme signal d'erreur. Ce signal LA1Q, correspondant à la composante en quadrature du signal de résonance à la fréquence de Larmor, est toujours nul lorsque $\theta_f$ vaut 90° et est antisymétrique dans une fenêtre de +/- 15° autour de cette valeur.

L'asservissement de $\theta_f$ à 90° pour le pilotage de l'angle du champ RF $\theta_{RF}$ quand ce dernier est utilisé pour excité la résonance peut être réalisé de plusieurs manières. Pour une structure de magnétomètre bi-bloc, cela est réalisé par construction en alignant sur le rotor les axes de la polarisation $\vec{E}$ et du champ RF $\overrightarrow{B_{RF}}$, l'asservissement réalisé sur $\theta_{pol}$ à l'aide du signal L1AQ permettant de garantir également celui de $\theta_{RF}$. Pour une structure de magnétomètre monobloc, le pilotage de $\theta_{RF}$ est physiquement découplé de celui de $\theta_{pol}$, et il est alors généralement réalisé à partir de la connaissance de la valeur de $\theta_{pol}$. Cette dernière est connue au travers d'une caractérisation a priori du système de pilotage de la polarisation (une table de correspondance par exemple entre tension RMS de pilotage et angle de polarisation d'un rotateur de rotation de polarisation à base par exemple de cristaux liquides). Il suffit alors d'aligner le champ RF à l'aide d'un dispositif de bobines pour maintenir en permanence $\theta_{RF} = \theta_{pol}$.

En pratique deux orientations de $\theta_{pol}$ (respectivement de $\theta_{RF}$) et donc de $\vec{E}$ (respectivement de $\overrightarrow{B_{RF}}$) dans le plan de rotation de la polarisation sont possibles (en tout cas lorsque $\vec{B}$ n'est pas parallèle à $\vec{k}$, car alors toutes les valeurs de $\theta_{pol}$, respectivement de $\theta_{RF}$, sont correctes). $\theta_f$ n'est en effet formellement défini que sur [0°-180°] alors que $\theta_{pol}$ (respectivement $\theta_{RF}$) est pilotable sur 360°. Ainsi comme représenté sur la figure 3, une extension formelle de $\theta_f$ sur [0°-360°] par symétrie autour de 180° crée deux points d'asservissement possibles $\theta_{pol1}$ et $\theta_{pol2} = \theta_{pol1} + 180°$ (respectivement $\theta_{RF1}$ et $\theta_{RF2}$

= $\theta_{RF1}$+180°, avec finalement $\theta_{RF1}$ = $\theta_{pol1}$ et $\theta_{RF2}$ = $\theta_{pol2}$) chacun associé à une fenêtre de +/- 15° où l'évolution du signal LA1Q est linéaire avec une pente respectivement négative et positive.

Au cours du démarrage du magnétomètre, celui-ci est asservi de manière aléatoire sur l'un des deux points de fonctionnement possibles $\theta_{pol1}$ ($\theta_{RF1}$) ou $\theta_{pol2}$ ($\theta_{RF2}$), tous deux correspondant à la configuration $\theta_f$ = 90° assurant le fonctionnement isotrope. La seule différence réside dans la détermination du signe de la pente locale du signal LA1Q qui permet d'orienter correctement le sens de la rotation à réaliser sur la polarisation et le champ RF afin de minimiser le signal d'erreur LA1Q dans la boucle d'asservissement de $\theta_f$ à 90°.

Néanmoins, plusieurs inconvénients et limitations liés aux architectures et aux principes de fonctionnement susmentionnés peuvent être identifiés.

Dans une architecture monobloc, toute dérive non mesurable in situ et non corrigeable des caractéristiques du système permettant de faire tourner la polarisation peut dégrader les performances voire empêcher le fonctionnement isotrope de l'instrument. Ainsi dans un schéma d'instrument monobloc utilisant un signal RF pour exciter la résonance magnétique, toute dérive de la connaissance absolue de $\theta_{pol}$ entraine directement un défaut d'alignement sur $\theta_{RF}$. La polarisation $\vec{E}$ et le champ RF $\overrightarrow{B_{RF}}$ se désalignent, ce qui entraine une baisse des niveaux de résonance mesurés, pouvant aller jusqu'à un défaut d'opérabilité de l'instrument. De plus les systèmes de rotation de polarisation monolithiques sont limités en amplitude de rotation ce qui peut nécessiter d'opérer des retournements de 180° pour assurer la continuité du fonctionnement de l'instrument quelle que soit l'orientation du champ $\vec{B}$ dans le repère du capteur. Il faut alors basculer du point de fonctionnement $\theta_{pol1}$ vers $\theta_{pol2}$ ou réciproquement. Ce basculement est opéré sur la connaissance a priori ou par une caractérisation au préalable des performances du système de rotation, si bien que toute variation non corrigée peut alors entrainer un retournement supérieur ou inférieur à 180°, ce qui réduit alors la zone de validité pour le bon fonctionnement de l'asservissement angulaire. Dans le pire des cas, l'asservissement peut être perdu lors de la phase de retournement ce qui nécessite alors de redémarrer l'instrument.

Dans tous les cas, un démarrage du magnétomètre réalisé alors que le champ magnétique $\vec{B}$ est aligné ou proche de l'axe optique $\vec{k}$ est problématique car le signal LA1Q est alors quasi nul pour toutes les valeurs de $\theta_{pol}$ et $\theta_{RF}$ (toutes les valeurs de $\theta_{pol}$ et $\theta_{RF}$ sont possibles en théorie). Il est alors virtuellement impossible de déterminer le signe de la pente du signal LA1Q en fonction de $\theta_{pol}$ et $\theta_{RF}$, et lorsque le champ $\vec{B}$ s'écarte progressivement de la direction de $\vec{k}$ l'asservissement de $\theta_{pol}$ et de $\theta_{RF}$ peut alors diverger si ce signe a été mal déterminé. Une telle divergence entraine un défaut d'opérabilité du magnétomètre car l'asservissement va piloter la polarisation $\vec{E}$ et le champ RF $\overrightarrow{B_{RF}}$ hors de la zone de fonctionnement, directement vers une zone d'ombre de signal LA0 ou LA2. Il est alors nécessaire de lancer une nouvelle procédure de démarrage du magnétomètre.

De manière similaire, à chaque fois que l'orientation du champ $\vec{B}$ s'approche de celle de $\vec{k}$, il est difficile voire impossible de maintenir l'asservissement de $\theta_{pol}$ (et donc de $\theta_{RF}$) avec un signal LA1Q quasi ou complètement nul. Il est alors possible lorsque $\vec{B}$ s'écarte à nouveau de $\vec{k}$ que l'orientation théorique de $\theta_{pol}$ (et donc de $\theta_{RF}$) ait varié significativement et que cette variation soit telle que l'on soit sorti de la zone de fonctionnement de l'asservissement de $\theta_{pol}$ (et de $\theta_{RF}$). Là encore, il est nécessaire de redémarrer le magnétomètre.

Enfin, dans certaines architectures et modes de fonctionnement, aucun signal de résonance magnétique de type « LA1Q » n'est intrinsèquement utilisable pour asservir la polarisation du faisceau et réaliser ainsi un magnétomètre isotrope. C'est le cas en général des magnétomètres dit « tout-optique » où la résonance magnétique est excitée non pas de manière magnétique par un champ RF mais à l'aide d'une modulation d'intensité ou de longueur d'onde du faisceau optique. Pour résoudre en partie ce problème, il est possible (comme cela est par exemple proposé dans l'article de T. Wu et al., « A dead-zone free 4He atomic magnetometer with intensity-modulated linearly polarized light and a liquid crystal polarization rotator », Review of Scientific Instruments 86/10, 2015) de moduler la polarisation du faisceau optique, ce qui permet de générer artificiellement un signal de d'asservissement de $\theta_f$ à 90°. Néanmoins on retrouve les mêmes limitations que celles mentionnées précédemment s'agissant de l'extrême sensibilité ou de l'indétermination de mise en oeuvre lorsque le champ $\vec{B}$ est aligné ou proche de la direction de propagation du faisceau optique $\vec{k}$ car dans ce cas aussi le signal d'erreur utilisé pour asservir $\theta_f$ à 90° s'annule quelle que soit la valeur de $\theta_{pol}$.

**EXPOSÉ DE L'INVENTION**

Un objectif de l'invention est de répondre à l'un et/ou l'autre des inconvénients susmentionnés, notamment en ce qu'ils ont trait à la difficulté d'asservir correctement $\theta_f$ à 90° et donc d'assurer le fonctionnement isotrope du magnétomètre, lorsque d'une part les caractéristiques de pilotage du système de rotation de la polarisation viennent à dériver et d'autre part lorsque le champ magnétique $\vec{B}$ vient à être proche de la direction de propagation du faisceau optique $\vec{k}$.

A cet effet, l'invention propose un procédé de mesure d'un champ magnétique ambiant à l'aide d'un magnétomètre scalaire. Le magnétomètre comprend :

- une source de pompage optique apte à émettre un faisceau laser en direction d'une cellule remplie d'un gaz selon une direction de propagation,
- un rotateur de polarisation apte à faire tourner la direction de polarisation du faisceau laser en étant piloté par une consigne d'orientation de polarisation,
- une source d'excitation de résonance magnétique,
- un photodétecteur recevant le faisceau laser ayant traversé la cellule et fournissant un signal électrique, et
- un premier système d'asservissement configuré pour réaliser un asservissement en fréquence de la source d'excitation de la résonance magnétique à partir d'une première composante du signal électrique.

Le procédé comprend une étape de mesure vectorielle du champ magnétique ambiant et, à partir de ladite mesure, une étape de calcul d'un écart d'alignement $\alpha_{\vec{B},\vec{k}}$ du champ magnétique ambiant avec la direction de propagation du faisceau laser et d'un angle de rotation théorique $\theta_{pol\ theo}$ à apporter à la polarisation du faisceau laser pompe dans un plan orthogonal à la direction de propagation du faisceau laser pour que la polarisation du faisceau laser soit orthogonale au champ magnétique ambiant. Lorsque l'écart d'alignement est inférieur à un seuil, le procédé utilise pour consigne d'orientation de polarisation la valeur dudit angle de rotation théorique ou la valeur courante de ladite consigne lorsqu'il a été détecté que l'écart d'alignement est inférieur au seuil.

Certains aspects préférés mais non limitatifs de ce procédé sont les suivants :

- le magnétomètre scalaire comprenant un deuxième système d'asservissement configuré pour fournir au rotateur de polarisation, à partir d'une deuxième composante du signal électrique, un signal de commande visant à maintenir la direction de polarisation du faisceau laser orthogonale au champ magnétique ambiant, il comprend en outre une étape d'inhibition du second système d'asservissement lorsque l'écart d'alignement est inférieur au seuil ;
- la source d'excitation est une source RF, et la mesure vectorielle est réalisée à l'aide du magnétomètre lui-même en venant alimenter des bobines entourant la cellule par un courant ayant une fréquence prédéterminée propre à chaque bobine, puis démoduler de manière synchrone le signal électrique à chacune des fréquences prédéterminées et déterminer des composantes du champ magnétique ambiant selon les axes des bobines ;
- la source d'excitation est une source RF et la mesure vectorielle et la mesure du champ vectorielle n'est pas réalisée par le magnétomètre scalaire ;
- il comprend le pilotage de l'orientation du champ magnétique radiofréquence dans le plan orthogonal à la direction de propagation du faisceau laser à partir dudit angle de rotation théorique ;
- le rotateur de polarisation comprend un polariseur motorisé en rotation par un moteur venant également piloter l'orientation du champ magnétique radiofréquence dans le plan orthogonal à la direction de propagation du faisceau laser ;
- il comprend la comparaison dudit angle de rotation théorique avec une valeur d'angle de rotation fournie par une loi de pilotage du rotateur de polarisation associant des valeurs de consigne d'orientation de polarisation à des valeurs d'angle de rotation, et la correction de la loi de pilotage en fonction du résultat de la comparaison.

L'invention porte également sur un système de mesure d'un champ magnétique, comportant un magnétomètre scalaire et un contrôleur configuré pour mettre en oeuvre du procédé. La source d'excitation de résonance magnétique peut être une source RF ou une un modulateur du faisceau laser. Le rotateur de polarisation peut être un rotateur de polarisation à cristal liquide.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

- la figure 1 est un schéma représentant la rotation de la polarisation dans le plan normal à la direction de propagation du faisceau optique $\vec{k}$ ainsi que celle du champ RF lorsque celui-ci est utilisé pour exciter la résonance magnétique;
- la figure 2 représente l'évolution des signaux LA0 et LA1Q en fonction de l'orientation relative $\theta_f$ entre la direction de polarisation $\vec{E}$ et le champ magnétique ambiant $\vec{B}$ ;
- la figure 3 représente l'évolution du signal LA1Q en fonction de l'orientation relative $\theta_f$ entre la direction de polarisation $\vec{E}$ et le champ magnétique ambiant $\vec{B}$ étendue sur [0°-360°];
- la figure 4 est un schéma d'un système de mesure de champ magnétique selon un mode de réalisation possible de l'invention utilisant un champ RF pour exciter la résonance magnétique.

## EXPOSÉ DÉTAILLÉ DE MODES DE RÉALISATION PARTICULIERS

L'invention porte sur un procédé et un système de mesure d'un champ magnétique ambiant à l'aide d'un magnétomètre scalaire.

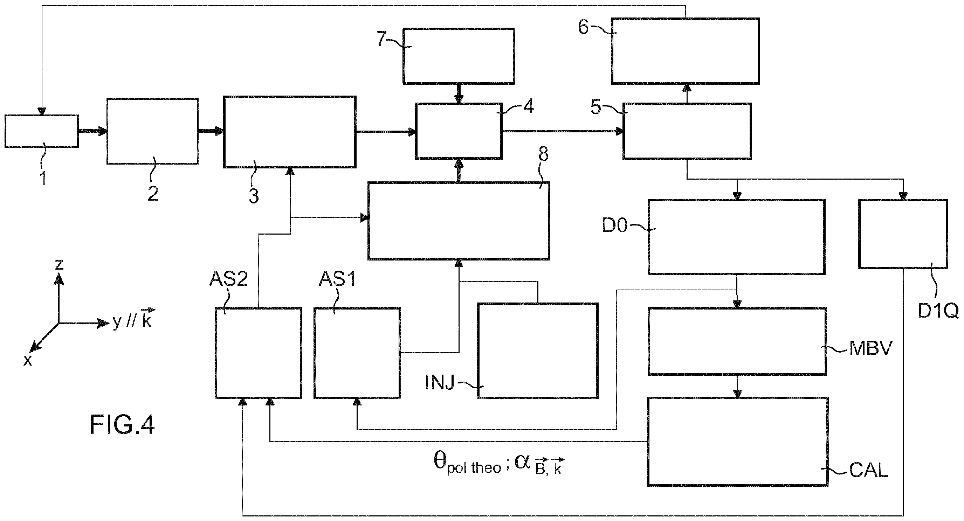

En référence à la figure 4, le magnétomètre scalaire comprend une source de pompage optique 1 apte à émettre un faisceau laser en direction d'une cellule 4 remplie d'un gaz (par exemple de l'hélium ou un gaz alcalin) selon une direction de propagation $\vec{k}$. Le faisceau laser émis par la source 1 traverse un polarisateur rectiligne 2 et un rotateur de polarisation 3 apte à faire tourner la direction de polarisation du faisceau laser en étant piloté par une consigne d'orientation de polarisation.

Le magnétomètre comporte par ailleurs une source d'excitation de résonance magnétique ainsi qu'un photodétecteur 5 recevant le faisceau laser ayant traversé la cellule et fournissant un signal électrique. Dans une mise en oeuvre possible d'un tel magnétomètre scalaire tel que décrit sur la figure 4, la source d'excitation de résonance magnétique est une source RF 8 qui comprend a minima une première et une deuxième bobine d'axes orthogonaux (selon les axes x et z orthogonaux au trajet optique $\vec{k}$) entourant la cellule 4 et alimentées par un générateur radiofréquence pour y générer un champ magnétique radiofréquence $\overrightarrow{B_{RF}}$. Dans une variante de réalisation non représentée, l'excitation de la résonance magnétique n'est pas réalisée de manière magnétique par un champ RF mais de manière optique à l'aide par exemple d'une modulation d'intensité ou de longueur d'onde du faisceau optique.

Si nécessaire, un système de décharge HF 7 permet d'exciter les atomes de gaz de la cellule, pour peupler l'état sur lequel on souhaite réaliser l'expérience de résonance magnétique (par exemple l'état métastable $2^3S1$ dans le cas de l'hélium 4).

Un dispositif 6 de détection et d'asservissement sur une raie de transition atomique, par exemple sur la raie $D_0$ à 1083 nm dans le cas de l'hélium 4, est placé en sortie du photodétecteur 5 et permet d'accorder la longueur d'onde de pompage du faisceau laser.

Le fonctionnement du magnétomètre est assuré au moyen d'un premier système d'asservissement AS1 configuré pour réaliser un asservissement en fréquence de la source d'excitation à partir d'une première composante du signal électrique. Et l'isotropie de ce fonctionnement peut être assurée au moyen d'un deuxième système d'asservissement AS2 configuré pour fournir au rotateur de polarisation 3, à partir d'une deuxième composante du signal électrique, un signal de commande (consigne d'orientation de polarisation) visant à maintenir la direction de polarisation du faisceau laser orthogonale au champ magnétique ambiant et, le cas échéant, à orienter le champ RF des bobines 8 colinéairement à la polarisation à partir de la connaissance de la valeur en cours de $\theta_{pol}$ appliquée au rotateur de polarisation.

Lorsque la source d'excitation est une source RF 8 comme cela est le cas sur la figure 4, le premier système d'asservissement AS1 est alors configuré pour asservir la fréquence du générateur radiofréquence à la fréquence de Larmor du gaz remplissant la cellule en exploitant en tant que première composante du signal électrique la composante continue LA0 du signal électrique ou la composante LA2 en phase à la fréquence double de la fréquence de Larmor du signal électrique.

Le deuxième système d'asservissement AS2 exploite quant à lui en tant que deuxième composante du signal électrique la composante LA1Q en quadrature de phase à la fréquence de Larmor du signal électrique. La minimisation de cette composante LA1Q par le pilotage de $\theta_{pol}$ permet alors d'asservir la position de la polarisation de telle sorte que $\theta_f$ soit constamment égal à +/- 90°. Ce pilotage se fait par exemple au travers de la tension RMS $U_{RMS}$ appliquée à un rotateur de polarisation à cristaux liquides. La connaissance des caractéristiques de la loi de pilotage associée $\theta_{pol} = g(U_{RMS})$ permet de remonter à la valeur courante de $\theta_{pol}$ et donc de piloter également l'orientation du champ RF en maintenant en permanence $\theta_{RF} = \theta_{pol}$ dans le cas d'une structure de magnétomètre monobloc.

Le magnétomètre comporte ainsi un circuit de détection de la première composante D0 et, le cas échéant, un circuit de détection de la deuxième composante D1Q couplés, d'une part, au photodétecteur 5, et, d'autre part, respectivement au premier système d'asservissement AS1 et au deuxième système d'asservissement AS2.

Dans une autre mise en oeuvre possible, le magnétomètre scalaire est un magnétomètre « tout-optique » où la résonance magnétique n'est pas excitée par un champ RF, mais de manière optique à l'aide par exemple d'une modulation d'intensité ou de longueur d'onde du faisceau laser. La fréquence de la modulation est asservie par le premier système d'asservissement AS1 en exploitant une mesure d'amplitude des signaux LA0 ou LA2.

Dans cette autre mise en oeuvre, un signal de type LA1Q n'est pas disponible pour assurer l'isotropie du magnétomètre. Toutefois, à l'image de ce qui est exposé dans l'article de T. Wu et al. mentionné précédemment, une modulation de la polarisation peut être réalisée afin de générer artificiellement un signal d'erreur comparable pour réaliser l'asservissement de $\theta_f$ à 90°. Le rotateur de polarisation est pour ce faire piloté à l'aide du deuxième système d'asservissement AS2 en exploitant le signal issu d'une détection synchrone sur le signal électrique fourni par le photodétecteur au fondamental d'une modulation superposée au signal AC de pilotage du rotateur de polarisation.

L'invention propose d'utiliser une information portant sur l'orientation relative entre $\vec{k}$, $\vec{B}$ et $\vec{E}$ autre que celle classiquement obtenue par le signal de résonance LA1Q ou par celui correspondant à la modulation de polarisation, pour piloter et asservir la direction de $\vec{E}$ par rapport à celle de $\vec{B}$ (et celle de $\overrightarrow{B_{RF}}$ dans les structures utilisant ce moyen d'excitation des résonances magnétiques, comme celui décrit sur la figure 4) afin d'assurer le fonctionnement isotrope.

Cette information est la connaissance qui peut être grossière de $\vec{B}$ ou de son orientation dans le repère du magnétomètre. Cette information peut être obtenue par exemple à partir d'une mesure vectorielle du champ réalisée par le magnétomètre lui-même (le magnétomètre étant utilisé en mode mesure scalaire et vectorielle) ou par tout autre système externe au capteur (par exemple par connaissance géographique, ou par une mesure externe avec des capteurs moins performants, par exemple des capteurs MEMS). Le procédé selon l'invention comprend ainsi une étape de mesure vectorielle du champ magnétique ambiant.

Reprenant l'exemple d'une source d'excitation venant générer un champ magnétique RF comme cela est le cas sur la figure 4, la mesure vectorielle du champ magnétique ambiant peut être réalisée par le magnétomètre scalaire. La source d'excitation 8 comprend alors une troisième bobine d'axe orthogonal aux axes des première et deuxième bobines, et la mesure vectorielle du champ magnétique ambiant comprend, au moyen du bloc INJ sur la figure 4, l'alimentation de chacune des bobines de la source RF 8 par un courant ayant une fréquence prédéterminée propre à cette bobine. Et cette mesure comprend en outre, au moyen du bloc MBV sur la figure 4, la démodulation synchrone du signal électrique à chacune des fréquences prédéterminées et la détermination des composantes du champ magnétique ambiant selon les axes des bobines. On pourra trouver un exemple d'une telle mesure vectorielle dans le brevet EP 1 344 075 B1.

La mesure vectorielle du champ magnétique peut être précédée des étapes suivantes. On opère tout d'abord le magnétomètre en mode scalaire. Les atomes de gaz sont excités via la décharge HF et pompés par le faisceau laser accordée sur la transition atomique d'intérêt. On effectue une rampe de champ RF avec une fréquence $f_{RF}$ et une orientation $\theta_{RF}$ variables et on recherche des signaux de résonance LA0 ou LA2. Conjointement, l'orientation $\theta_{pol}$ de la polarisation $\vec{E}$ peut être également pilotée par une rampe d'amplitude similaire à celle du champ RF (caractérisation initiale de la loi de pilotage $\theta_{pol} = g(U_{RMS})$ sous forme par exemple d'une table de correspondance ou d'une loi de variation polynomiale). Cette recherche de signaux magnétiques se fait donc indépendamment d'un réglage optimum de $\theta_{pol}$ et de $\theta_{RF}$ par rapport au point de fonctionnement final $\theta_f$ = 90° visé (on peut effectivement avoir des signaux même en position non idéale).

Quand des signaux de résonance sont détectés, on fige $\theta_{pol}=\theta_{RF}$ à la valeur en cours et on asservit le champ magnétique RF sur le signal de résonance LA0 ou LA2. On opère également la détection et la mesure du signal LA1Q même si sa mesure n'est pas encore directement utilisée.

La mesure vectorielle du champ magnétique ambiant est alors réalisée au moyen de l'injection des trois modulations à fréquences connues sur le triaxe vectoriel et de la mesure de l'amplitude des projections respectives sur le champ scalaire. Le magnétomètre est ainsi opéré en mode scalaire + vectoriel, même si la position $\theta_{pol}$ et de $\theta_{RF}$ en cours n'est pas optimale. A partir de ce moment $\vec{B}$ est connu dans le repère de l'instrument.

La direction optimale de la polarisation $\vec{E}$ (et de $\overrightarrow{B_{RF}}$ dans le cadre du dispositif de la figure 4 avec excitation RF) dans le plan de rotation normal à $\vec{k}$ pour fonctionner dans la configuration $\theta_f$ = 90° est alors donnée par le calcul du produit vectoriel $\vec{k} \wedge \vec{B}$. Le vecteur résultant de ce produit vectoriel est orthogonal à la fois à $\vec{k}$ et à $\vec{B}$. La direction de ce vecteur permet alors de déterminer directement les deux points de fonctionnement possibles $\theta_{pol1}$ et $\theta_{pol2} = \theta_{pol1}+180°$ (dits angles de rotation théorique $\theta_{pot\,theo}$ dans ce qui suit, correspondants également à $\theta_{RF1}$ et $\theta_{RF2}$ dans la mise en oeuvre avec excitation RF de la figure 4) dans le plan de rotation orthogonal à $\vec{k}$.

Ainsi, une fois la mesure de $\vec{B}$ connue dans le repère de l'instrument, le procédé comprend le calcul, à partir de ladite mesure vectorielle de $\vec{B}$, de l'angle de rotation théorique $\theta_{pot\,theo}$ à apporter à la polarisation du faisceau laser dans le plan orthogonal à la direction de propagation $\vec{k}$ du faisceau laser pour que la polarisation du faisceau laser soit orthogonale au champ magnétique ambiant.

On peut également déterminer l'angle $\alpha_{\vec{B},\vec{k}}$ entre $\vec{B}$ et $\vec{k}$ afin de savoir si on est ou si on s'approche d'une zone problématique où le signal de pilotage utilisé pour orienter la polarisation n'est pas présent ou va disparaître (c'est le cas quand $\vec{B}$ et $\vec{k}$ sont alignés ou proche de l'être). Le calcul de cet angle $\alpha_{\vec{B},\vec{k}}$ caractérisant un écart d'alignement entre $\vec{B}$ et $\vec{k}$ et de l'angle de rotation théorique $\theta_{pol\,theo}$ est assuré par le bloc CAL sur la figure 4. L'angle $\alpha_{\vec{B},\vec{k}}$ est par exemple donné par *acos*

$$\left( \frac{|\vec{k}.\vec{B}|}{\|\vec{k}\|\|\vec{B}\|} \right)$$

avec $\vec{k}.\vec{B}$ le produit scalaire, $|.|$ la valeur absolue et $\|.\|$ la norme. Cet angle est arbitrairement limité ici dans la fenêtre de calcul de [0° ; 90°] par la valeur absolue effectuée sur le produit scalaire du numérateur dans la formule précédente, mais peut très bien être utilisé sur une définition de [0° ; 180°].

Lorsque l'écart d'alignement entre $\vec{B}$ et $\vec{k}$ est inférieur à un seuil (c'est-à-dire que l'angle $\alpha_{\vec{B},\vec{k}}$ est inférieur au seuil, par exemple un seuil égal à 5°), la commande du rotateur de polarisation n'est pas réalisée au moyen du deuxième système d'asservissement AS2 qui est alors inhibé. On vient alors poursuivre le pilotage de la polarisation en fixant (tant que l'écart d'alignement reste inférieur au seuil) la consigne d'orientation de polarisation fournie au rotateur de polarisation à sa valeur courante lorsqu'il est détecté que l'écart d'alignement est inférieur au seuil ou à la valeur dudit angle de rotation théorique. On notera qu'en venant figer la consigne à sa valeur en cours lorsqu'il est détecté que l'écart d'alignement entre $\vec{B}$ et $\vec{k}$ est inférieur au seuil, on évite d'utiliser le rotateur de polarisation dans des zones de rotation de polarisation trop rapides en regard de ses caractéristiques de temps de réponse.

Le champ RF, s'il est utilisé dans l'architecture du magnétomètre, reste quant à lui toujours piloté à l'aide de l'angle de rotation théorique $\theta_{pol\,theo}$ quelle que soit l'écart d'alignement. La connaissance de $\theta_{pot\,theo}$ permet donc ainsi d'orienter de manière très précise le champ RF de telle sorte que $\theta_{RF} = \theta_{pol\,theo}$ indépendamment de l'utilisation de la connaissance de la valeur courante de la consigne d'orientation de polarisation $\theta_{pol}$ ce qui permet de s'affranchir des effets de dérive des caractéristiques du rotateur sur ce point. Dans cette situation les mesures fournies par l'instrument sont valides.

Lorsque l'écart d'alignement de $\vec{B}$ avec $\vec{k}$ devient supérieur au seuil, le pilotage de l'orientation du champ magnétique radiofréquence dans le plan orthogonal à la direction de propagation du faisceau laser reste réalisé à partir dudit angle de rotation théorique : $\theta_{RF} = \theta_{pol\,theo}$. Le signal LA1Q peut quant à lui être utilisé pour contrôler l'orientation de la polarisation $\theta_{pol}$. Cela est notamment possible dans les architectures monobloc intégrant par exemple un rotateur de polarisation du type rotateur à cristal liquide.

Dans ce cadre, le deuxième système d'asservissement AS2 délivre un signal de commande au rotateur de polarisation, typiquement une tension, dont la valeur peut être mise en correspondance avec une valeur d'angle de rotation de la polarisation par connaissance des caractéristiques de pilotage de ce dernier (caractérisation initiale de la loi de pilotage $\theta_{pol} = g(U_{RMS})$ sous forme par exemple d'une table de correspondance ou d'une loi de variation polynomiale). Il s'avère alors possible de comparer l'angle de rotation théorique $\theta_{pol\,theo}$ et la valeur d'angle de rotation en cours $\theta_{pol}$ déduite par la connaissance des caractéristiques de pilotage du rotateur. Une telle comparaison permet de corriger et mettre continument à jour ces caractéristiques de pilotage sur les valeurs de $\theta_{pol\,theo}$ parcourues lors de cette mise en oeuvre. Les valeurs caractérisant ce comportement (loi de pilotage de type table de correspondance ou coefficients d'une loi polynomiale par exemple) peuvent en effet se révéler inexactes en fonction de l'environnement (température par exemple) et du degré de vieillissement du rotateur. En l'absence de correction, on peut donc se retrouver à opérer le magnétomètre avec une polarisation $\vec{E}$ et un champ RF $\vec{B_{RF}}$ désalignés, ce qui va dégrader les amplitudes des signaux de résonance et nuire à la performance. Le décalage entre la valeur $\theta_{pol\,theo}$ réellement nécessaire pour assurer l'orthogonalité de $\vec{E}$ et de $\vec{B}$ et la valeur $\theta_{pol}$ déduite de la loi de pilotage peut même progressivement se décaler de manière si importante qu'un retournement de +/- 180 ° peut alors amener le magnétomètre dans une zone de perte des asservissements.

A cet égard, on relèvera que lorsque se présente le cas où $\theta_{pol\,theo}$ atteint un des seuils de pilotage en orientation possible du rotateur de polarisation (seuil bas ou haut) il faut alors effectuer un retournement de +/- 180° de l'orientation de la polarisation afin de pouvoir poursuivre la mise en oeuvre du fonctionnement isotrope. Ce retournement de 180° doit aussi être effectué sur le champ $\vec{B_{RF}}$. Le pilotage du saut de rotation de polarisation adéquat reste déterminé à partir des caractéristiques connues de la loi de pilotage $\theta_{pol} = g(U_{RMS})$ tout en inversant le signe de l'asservissement sur la composante LA1Q avant de le relâcher. On peut alors également noter la consigne de tension réelle correspondant au saut de +/- 180 ° sur la polarisation et mettre à jour les caractéristiques de la loi de pilotage du rotateur. Cela permet de gagner en précision/rapidité sur les sauts suivants en utilisant directement les valeurs mémorisées et remises à jour à chaque saut.

On relèvera que suivant le besoin et la configuration d'instrument mise en oeuvre, la connaissance de l'information de mesure vectorielle du champ ambiant peut être exploitée en complément d'un signal d'erreur déjà présent (de type « LA1Q » par exemple) ou en remplacement intégral. La connaissance de $\theta_{pol\,theo}$ peut ainsi être utilisée en tant qu'unique signal de pilotage de l'orientation de la polarisation si l'on ne souhaite pas utiliser de signal type LA1Q ou que celui-ci n'est pas présent pour assurer le pilotage du rotateur de polarisation.

Dans une variante de réalisation (architecture bi-bloc), le rotateur de polarisation comprend un polariseur motorisé en rotation par un moteur venant également piloter l'orientation du champ magnétique radiofréquence dans le plan orthogonal à la direction de propagation du faisceau laser. Dans un tel cas de figure, lorsque l'écart d'alignement est supérieur au seuil, le signal LA1Q peut être utilisé pour piloter le moteur et ainsi pour contrôler conjointement l'orientation de la polarisation $\theta_{pol}$ et l'orientation du champ magnétique RF $\theta_{RF}$ qui auront été alignés par construction. Et lorsque l'écart d'alignement est inférieur au seuil, le moteur est piloté à l'aide de l'angle de rotation théorique de manière à avoir $\theta_{pol} = \theta_{RF} = \theta_{pol\,theo}$.

Dans une autre variante de réalisation, la mesure vectorielle du champ magnétique ambiant n'est pas réalisée par le magnétomètre qui ne fournit donc qu'une mesure scalaire. Ladite mesure vectorielle est alors réalisée par un système externe au magnétomètre comme indiqué précédemment. On retiendra que dans le cadre de cette variante, seules deux bobines orientées selon les axes $\vec{x}$ et $\vec{z}$ orthogonaux au trajet optique selon $\vec{k}$ sont nécessaires pour assurer le contrôle de la direction du champ radiofréquence.

Dans un autre exemple de réalisation, le magnétomètre scalaire est un magnétomètre tout-optique dont la source d'excitation de résonance magnétique comprend un modulateur du faisceau laser asservi par le premier système d'asservissement AS1. Le modulateur réalise par exemple une modulation d'intensité ou de longueur d'onde du faisceau laser. La modulation d'intensité du faisceau laser peut être réalisée par un modulateur acousto-optique, et la modulation de la longueur d'onde peut être réalisée par modulation du courant de pompe de la diode laser.

Avec une information d'orientation de $\vec{B}$ dans le repère du magnétomètre fournie de manière externe, on détermine comme précédemment l'orientation idéale $\theta_{pol\ theo}$ de la polarisation pilotée par le rotateur de polarisation.

Si aucun signal de résonance de type LA1Q n'est utilisé pour asservir l'orientation de la polarisation, le magnétomètre est opéré dans une configuration fixe de $\theta_f = 90°$ à l'aide de l'angle de rotation théorique $\theta_{pol\ theo}$ ce qui permet d'assurer son caractère isotrope ($\theta_{pal} = \theta_{pol\ theo}$) quel que soit l'écart d'alignement de de $\vec{B}$ avec $\vec{k}$.

Si un signal de type LA1Q ou similaire (par exemple issu d'une modulation supplémentaire de la polarisation effectuée sur le rotateur comme exposé dans l'article de T. Wu et al. mentionné précédemment) est utilisé pour asservir l'orientation de la polarisation, ce dernier reste utilisé pour opérer la rotation de polarisation lorsque l'écart d'alignement de $\vec{B}$ avec $\vec{k}$ est supérieur au seuil. En revanche, lorsque l'écart d'alignement de $\vec{B}$ avec $\vec{k}$ est inférieur au seuil, on peut fixer la consigne du rotateur de polarisation directement à la valeur théorique $\theta_{pol\ theo}$.

L'invention n'est pas limitée au procédé tel que précédemment décrit mais s'étend à un système de mesure d'un champ magnétique apte à mettre en oeuvre ce procédé et notamment un système comportant un magnétomètre scalaire qui comprend :

- une source de pompage optique apte à émettre un faisceau laser en direction d'une cellule remplie d'un gaz selon une direction de propagation,
- un rotateur de polarisation apte faire tourner la direction de polarisation du faisceau laser en étant piloté par une consigne d'orientation de polarisation,
- une source d'excitation de résonance magnétique,
- un photodétecteur recevant le faisceau laser ayant traversé la cellule et fournissant un signal électrique,
- un premier système d'asservissement configuré pour réaliser un asservissement en fréquence de la source d'excitation à partir d'une première composante du signal électrique,

le système étant caractérisé en ce qu'il comporte en outre un contrôleur configuré pour :

- calculer, à partir d'une mesure vectorielle du champ magnétique ambiant, un écart d'alignement du champ magnétique ambiant avec la direction de propagation du faisceau laser, et un angle de rotation théorique à apporter à la polarisation du faisceau laser pompe dans un plan orthogonal à la direction de propagation du faisceau laser pour que la polarisation du faisceau laser soit orthogonale au champ magnétique ambiant, et

- lorsque l'écart d'alignement est inférieur à un seuil, fixer la consigne d'orientation de polarisation à sa valeur courante ou à la valeur dudit angle de rotation théorique.

## Revendications

1. Procédé de mesure d'un champ magnétique ambiant à l'aide d'un magnétomètre scalaire qui comprend :

   - une source de pompage optique (1) apte à émettre un faisceau laser en direction d'une cellule (4) remplie d'un gaz selon une direction de propagation,
   - un rotateur de polarisation (3) apte à faire tourner la direction de polarisation du faisceau laser en étant piloté par une consigne d'orientation de polarisation,
   - une source d'excitation de résonance magnétique (8),
   - un photodétecteur (5) recevant le faisceau laser ayant traversé la cellule et fournissant un signal électrique,
   - un premier système d'asservissement (AS1) configuré pour réaliser un asservissement en fréquence de la source d'excitation de la résonance magnétique à partir d'une première composante (LA0) du signal électrique,

   le procédé étant **caractérisé en ce qu'**il comporte les étapes de :

   - mesure vectorielle du champ magnétique ambiant (MBV),
   - à partir de ladite mesure vectorielle, calcul (CAL) :

     o d'un écart d'alignement ($\alpha_{\vec{B},\vec{k}}$) du champ magnétique ambiant avec la direction de propagation du faisceau laser, et
     o d'un angle de rotation théorique ($\theta_{pol\ theo}$) à apporter à la polarisation du faisceau laser pompe dans un plan orthogonal à la direction de propagation du faisceau laser pour que la polarisation du faisceau laser soit orthogonale au champ magnétique ambiant,

   - lorsque l'écart d'alignement est inférieur à un seuil, utiliser pour consigne d'orientation de polarisation la valeur dudit angle de rotation théorique ou la valeur courante de ladite consigne lorsqu'il a été détecté que l'écart d'alignement est inférieur au seuil.

2. Procédé selon la revendication 1, dans lequel le magnétomètre scalaire comprend un deuxième système d'asservissement (AS2) configuré pour fournir au rotateur de polarisation (3), à partir d'une deuxième composante (LA1Q) du signal électrique, un signal de commande visant à maintenir la direction de polarisation du faisceau laser orthogonale au champ magnétique ambiant, le procédé comprenant en outre une étape d'inhibition du second système d'asservissement lorsque l'écart d'alignement est inférieur au seuil.

**3.** Procédé selon l'une des revendications 1 et 2, dans lequel la source d'excitation (8) comprend une première et une deuxième bobines d'axes orthogonaux entourant la cellule et alimentées par un générateur radiofréquence pour y générer un champ magnétique radiofréquence, dans lequel le premier système d'asservissement (AS1) est configuré pour asservir la fréquence du générateur radiofréquence à la fréquence de Larmor du gaz remplissant la cellule en exploitant en tant que première composante du signal électrique la composante continue (LA0) du signal électrique ou la composante en phase à la fréquence double de la fréquence de Larmor du signal électrique, dans lequel la source d'excitation (8) comprend une troisième bobine d'axe orthogonal aux axes des première et deuxième bobines, et dans lequel la mesure vectorielle du champ magnétique ambiant comprend l'alimentation de chacune des bobines par un courant ayant une fréquence prédéterminée propre à cette bobine, la démodulation synchrone du signal électrique à chacune des fréquences prédéterminées et la détermination des composantes du champ magnétique ambiant selon les axes des bobines.

**4.** Procédé selon l'une des revendications 1 et 2, dans lequel la source d'excitation (8) comprend une première et une deuxième bobines d'axes orthogonaux entourant la cellule et alimentées par un générateur radiofréquence pour y générer un champ magnétique radiofréquence, dans lequel le premier système d'asservissement (AS1) est configuré pour asservir la fréquence du générateur radiofréquence à la fréquence de Larmor du gaz remplissant la cellule en exploitant en tant que première composante du signal électrique la composante continue (LAO) du signal électrique ou la composante en phase à la fréquence double de la fréquence de Larmor du signal électrique, dans lequel la mesure du champ vectorielle n'est pas réalisée par le magnétomètre scalaire.

**5.** Procédé selon l'une des revendications 3 et 4, comprenant le pilotage de l'orientation du champ magnétique radiofréquence dans le plan orthogonal à la direction de propagation du faisceau laser à partir dudit angle de rotation théorique.

**6.** Procédé selon l'une des revendications 3 et 4, dans lequel le rotateur de polarisation (3) comprend un polariseur motorisé en rotation par un moteur venant également piloter l'orientation du champ magnétique radiofréquence dans le plan orthogonal à la direction de propagation du faisceau laser.

**7.** Procédé selon l'une des revendications 2 à 6, comprenant la comparaison dudit angle de rotation théorique avec une valeur d'angle de rotation fournie par une loi de pilotage du rotateur de polarisation associant des valeurs de consigne d'orientation de polarisation à des valeurs d'angle de rotation, et la correction de la loi de pilotage en fonction du résultat de la comparaison.

**8.** Système de mesure d'un champ magnétique, comportant un magnétomètre scalaire qui comprend :

- une source de pompage optique (1) apte à émettre un faisceau laser en direction d'une cellule (4) remplie d'un gaz selon une direction de propagation,
- un rotateur de polarisation (3) apte faire tourner la direction de polarisation du faisceau laser en étant piloté par une consigne d'orientation de polarisation,
- une source d'excitation de résonance magnétique (8),
- un photodétecteur (5) recevant le faisceau laser ayant traversé la cellule et fournissant un signal électrique,
- un premier système d'asservissement (AS1) configuré pour réaliser un asservissement en fréquence de la source d'excitation à partir d'une première composante (LA0) du signal électrique,

le système étant **caractérisé en ce qu'**il comporte en outre un contrôleur (CAL) configuré pour :

- calculer, à partir d'une mesure vectorielle du champ magnétique ambiant, un écart d'alignement ($\alpha_{\vec{B},\vec{k}}$) du champ magnétique ambiant avec la direction de propagation du faisceau laser, et un angle de rotation théorique ($\theta_{pol\ theo}$) à apporter à la polarisation du faisceau laser pompe dans un plan orthogonal à la direction de propagation du faisceau laser pour que la polarisation du faisceau laser soit orthogonale au champ magnétique ambiant, et
- lorsque l'écart d'alignement est inférieur à un seuil, utiliser pour consigne d'orientation de polarisation la valeur dudit angle de rotation théorique ou la valeur courante de ladite consigne lorsqu'il a été détecté que l'écart d'alignement est inférieur au seuil.

**9.** Système selon la revendication 8, dans lequel le magnétomètre scalaire comprend un deuxième système d'asservissement (AS2) configuré pour fournir au rotateur de polarisation (3), à partir d'une deuxième composante (LA1Q) du signal électrique, un signal de commande visant à maintenir la direction de polarisation du faisceau laser orthogonale au champ magnétique ambiant, et dans lequel le contrôleur est en outre configuré pour inhiber le second système d'asservissement (AS2) lorsque l'écart d'alignement est inférieur au seuil.

**10.** Système selon l'une des revendications 8 et 9, dans lequel la source excitation (8) comprend une première et une deuxième bobines d'axes orthogonaux entourant la cellule et alimentées par un générateur radiofréquence pour y générer un champ magnétique radiofréquence, et dans lequel le premier système d'asservissement (AS1) est configuré pour asservir la fréquence du générateur radiofréquence à la fréquence de Larmor du gaz remplissant la cellule en exploitant en tant que première composante du signal électrique la composante continue (LA0) du signal électrique ou la composante en phase à la fréquence double de la fréquence de Larmor (LA2) du signal électrique.

**11.** Système selon l'une des revendications 8 et 9, dans lequel la source d'excitation (8) comprend un modulateur du faisceau laser asservi par le premier système d'asservissement (AS1).

**12.** Système selon l'une des revendications 8 à 11, dans lequel le rotateur de polarisation (3) est un rotateur de polarisation à cristal liquide.

**Patentansprüche**

**1.** Verfahren zum Messen eines magnetischen Umgebungsfelds mit Hilfe eines skalaren Magnetometers, welches umfasst:

 - eine optische Pumpquelle (1), welche dazu in der Lage ist, einen Laserstrahl in Richtung einer mit einem Gas gefüllten Zelle (4) entlang einer Ausbreitungsrichtung zu emittieren,
 - einen Polarisationsrotator (3), welcher in der Lage ist, die Polarisationsrichtung des Laserstrahls durch eine Anweisung für die Orientierung der Polarisation geführt zu drehen,
 - eine Anregungsquelle mit magnetischer Resonanz (8),
 - einen Fotodetektor (5), welcher den Laserstrahl empfängt, welcher die Zelle durchquert hat, und ein elektrisches Signal liefert,
 - ein erstes Steuersystem (AS1), welches dazu eingerichtet ist, eine Frequenzsteuerung der Anregungsquelle mit magnetischer Resonanz ausgehend von einer ersten Komponente (LA0) des elektrischen Signals durchzuführen,

wobei das Verfahren **dadurch gekennzeichnet ist, dass** es die Schritte umfasst:

 - vektorielles Messen des magnetischen Umgebungsfelds (MBV),
 - ausgehend von der vektoriellen Messung, Berechnen (CAL):

 o eines Abstands einer Ausrichtung ($\alpha_{\vec{B},\vec{k}}$) des magnetischen Umgebungsfelds von der Ausbreitungsrichtung des Laserstrahls, und
 o eines theoretischen Rotationswinkels ($\theta_{pol\,theo}$) zum Übertragen der Polarisation des Pump-Laserstrahls in eine Ebene orthogonal zu der Ausbreitungsrichtung des Laserstrahls, so dass die Polarisation des Laserstrahls orthogonal zu dem magnetischen Umgebungsfeld wird,

 - wenn der Abstand der Ausrichtung kleiner als ein Schwellenwert ist, Verwenden als Anweisung für die Orientierung der Polarisation des Werts des theoretischen Rotationswinkels oder des momentanen Werts der Anweisung, wenn detektiert worden ist, dass der Abstand der Ausrichtung kleiner als der Schwellenwert ist.

**2.** Verfahren nach Anspruch 1, wobei das skalare Magnetometer ein zweites Steuersystem (AS2) umfasst, welches dazu eingerichtet ist, an den Polarisationsrotator (3) ausgehend von einer zweiten Komponente (LA1Q) des elektrischen Signals ein Anweisungssignal auszugeben, welches darauf abzielt, die Polarisationsrichtung des Laserstrahls orthogonal zu dem magnetischen Umgebungsfeld zu halten, wobei das Verfahren ferner einen Schritt eines Hemmens des zweitens Steuersystems umfasst, wenn der Abstand der Ausrichtung kleiner als der Schwellenwert ist.

**3.** Verfahren nach einem der Ansprüche 1 und 2, wobei die Anregungsquelle (8) eine erste und eine zweite Spule mit orthogonalen Achsen umfasst, welche die Zelle umgeben und von einem Radiofrequenzgenerator versorgt werden, um dort ein magnetisches Radiofrequenzfeld zu erzeugen, wobei das erste Steuersystem (AS1) dazu eingerichtet ist, die Frequenz des Radiofrequenzgenerators auf die Larmor-Frequenz des Gases zu regeln, welches die Zelle füllt, indem als erste Komponente des elektrischen Signals die kontinuierliche Komponente (LA0) des elektrischen Signals oder die Komponente in Phase mit der doppelten Frequenz der Larmor-Frequenz des elektrischen Signals ausgenutzt wird, wobei die Anregungsquelle (8) eine dritte Spule mit einer Achse orthogonal zu den Achsen der ersten und zweiten Spulen umfasst, und wobei die vektorielle Messung des magnetischen Umgebungsfelds das Versorgen von jeder der Spulen durch einen Strom mit einer vorbestimmten Frequenz, welche für diese Spule geeignet ist, die synchrone Demodulation des elektrischen Signal zu jeder der vorbestimmten Frequenzen und das Bestimmen der Komponenten des magnetischen Umgebungsfelds entlang der Achsen der Spulen umfasst.

4. Verfahren nach einem der Ansprüche 1 und 2, wobei die Anregungsquelle (8) eine erste und eine zweite Spule mit orthogonalen Achsen umfasst, welche die Zelle umgeben und von einem Radiofrequenzgenerator versorgt werden, um dort ein magnetisches Radiofrequenzfeld zu erzeugen, wobei das erste Steuersystem (AS1) dazu eingerichtet ist, die Frequenz des Radiofrequenzgenerators auf die Larmor-Frequenz des Gases zu regeln, welches die Zelle füllt, indem als erste Komponente des elektrischen Signals die kontinuierliche Komponente (LA0) des elektrischen Signals oder die Komponente in Phase mit der doppelten Larmor-Frequenz des elektrischen Signals ausgenutzt wird, wobei die Messung des vektoriellen Felds nicht durch das skalare Magnetometer durchgeführt wird.

5. Verfahren nach einem der Ansprüche 3 und 4, umfassend das Führen der Orientierung des magnetischen Radiofrequenzfelds in der Ebene orthogonal zu der Ausbreitungsrichtung des Laserstrahls ausgehend von dem theoretischen Rotationswinkel.

6. Verfahren nach einem der Ansprüche 3 und 4, wobei der Polarisationsrotator (3) einen in Rotation durch einen Motor angetriebenen Polarisator umfasst, wodurch es ebenfalls zu einem Führen der Orientierung des magnetischen Radiofrequenzfelds in der Ebene orthogonal zu der Ausbreitungsrichtung des Laserstrahls kommt.

7. Verfahren nach einem der Ansprüche 2 bis 6, umfassend das Vergleichen des theoretischen Rotationswinkels mit einem Wert eines Rotationswinkels, welcher von einer Vorschrift zum Führen des Polarisationsrotators geliefert wird, welche Werte zum Anweisen der Orientierung der Polarisation mit Werten des Rotationswinkels und der Korrektur in Verbindung setzt, sowie die Korrektur der Vorschrift zum Führen als Funktion des Ergebnisses des Vergleichs.

8. System zum Messen eines Magnetfelds, umfassend ein skalares Magnetometer, welches umfasst:

- eine optische Pumpquelle (1), welche dazu in der Lage ist, einen Laserstrahl in Richtung einer mit einem Gas gefüllten Zelle (4) entlang einer Ausbreitungsrichtung zu emittieren,
- einen Polarisationsrotator (3), welcher in der Lage ist, die Polarisationsrichtung des Laserstrahls durch eine Anweisung für die Orientierung der Polarisation geführt zu drehen,
- eine Anregungsquelle mit magnetischer Resonanz (8),
- einen Fotodetektor (5), welcher den Laserstrahl empfängt, welcher die Zelle durchquert hat, und ein elektrisches Signal liefert,
- ein erstes Steuersystem (AS1), welches dazu eingerichtet ist, eine Frequenzsteuerung der Anregungsquelle mit magnetischer Resonanz ausgehend von einer ersten Komponente (LA0) des elektrischen Signals durchzuführen,

wobei das System **dadurch gekennzeichnet ist, dass** es ferner eine Steuereinheit (CAL) umfasst, welche dazu eingerichtet ist:

- ausgehend von einer vektoriellen Messung des magnetischen Umgebungsfelds (MBV) einen Abstand einer Ausrichtung ($\alpha_{\vec{B},\vec{k}}$) des magnetischen Umgebungsfelds mit der Ausbreitungsrichtung des Laserstrahls und einen theoretischen Rotationswinkel ($\theta_{pol\ theo}$) zum Übertragen der Polarisation des Pump-Laserstrahls in eine Ebene orthogonal zu der Ausbreitungsrichtung des Laserstrahls zu berechnen, so dass die Polarisation des Laserstrahls orthogonal zu dem magnetischen Umgebungsfeld wird, und
- wenn der Abstand der Ausrichtung kleiner als ein Schwellenwert ist, als Anweisung für die Orientierung der Polarisation des Werts des theoretischen Rotationswinkels oder des momentanen Werts der Anweisung zu verwenden, wenn detektiert worden ist, dass der Abstand der Ausrichtung kleiner als der Schwellenwert ist.

9. System nach Anspruch 8, wobei das skalare Magnetometer ein zweites Steuersystem (AS2) umfasst, welches dazu eingerichtet ist, an den Polarisationsrotator (3) ausgehend von einer zweiten Komponente (LA1Q) des elektrischen Signals ein Anweisungssignal auszugeben, welches darauf abzielt, die Polarisationsrichtung des Laserstrahls orthogonal zu dem magnetischen Umgebungsfeld zu halten, wobei die Steuereinheit ferner dazu eingerichtet ist, das zweite Steuersystems (AS2) zu hemmen, wenn der Abstand der Ausrichtung kleiner als der Schwellenwert ist.

10. System nach einem der Ansprüche 8 und 9, wobei die Anregungsquelle (8) eine erste und eine zweite Spule mit orthogonalen Achsen umfasst, welche die Zelle umgeben und von einem Radiofrequenzgenerator versorgt werden, um dort ein magnetisches Radiofrequenzfeld zu erzeugen, und wobei das erste Steuersystem (AS1) dazu eingerichtet ist, die Frequenz des Radiofrequenzgenerators auf die Larmor-Frequenz des Gases zu regeln, welches die Zelle füllt, indem als erste Komponente des elektrischen Signals die kontinuierliche Komponente (LA0) des elektrischen Signals oder die Komponente in Phase mit der doppelten Frequenz der Larmor-Frequenz (LA2) des elektrischen Signals ausgenutzt wird.

**11.** System nach einem der Ansprüche 8 und 9, wobei die Anregungsquelle (8) einen Modulator für den Laserstrahl umfasst, welcher durch das erste Steuersystem (AS1) gesteuert wird.

**12.** System nach einem der Ansprüche 8 bis 11, wobei der Polarisationsrotator (3) ein Flüssigkristall-Polarisationsrotator ist.

**Claims**

**1.** A method for measuring an ambient magnetic field using a scalar magnetometer which comprises:

- an optical pumping source (1) able to emit a laser beam towards a cell (4) filled with a gas along a direction of propagation,
- a polarisation rotator (3) able to rotate the direction of polarisation of the laser beam by being driven by a polarisation orientation set point,
- a magnetic resonance excitation source (8),
- a photodetector (5) receiving the laser beam that passed through the cell and providing an electric signal,
- a first control system (AS1) configured to make a frequency control of the magnetic resonance excitation source from a first component (LA0) of the electric signal,

the method being **characterised in that** it includes the steps of:

- vectorially measuring the ambient magnetic field (MBV),
- from said vectorial measurement, calculating (CAL):

  ◦ an alignment deviation ($\alpha_{\vec{B},\vec{k}}$) of the ambient magnetic field relative to the direction of propagation of the laser beam, and
  ◦ a theoretical rotation angle ($\theta_{pol\,theo}$) to be supplied to the polarisation of the pump laser beam in a plane orthogonal to the direction of propagation of the laser beam such that the polarisation of the laser beam is orthogonal to the ambient magnetic field,

- when the alignment deviation is lower than a threshold, using as the polarisation orientation set point the value of said theoretical rotation angle or the current value of said set point when it has been detected that the alignment deviation is lower than the threshold.

**2.** The method according to claim 1, wherein the scalar magnetometer comprises a second control system (AS2) configured to provide to the polarisation rotator (3), from a second component (LA1Q) of the electric signal, a command signal for maintaining the direction of polarisation of the laser beam orthogonal to the ambient magnetic field, the method further comprising a step of inhibiting the second control system when the alignment deviation is lower than the threshold.

**3.** The method according to one of claims 1 and 2, wherein the excitation source (8) comprises a first and a second coil with orthogonal axes surrounding the cell and fed by a radiofrequency generator to generate a radiofrequency magnetic field therein, wherein the first control system (AS1) is configured to control the frequency of the radiofrequency generator to the Larmor frequency of the gas filling the cell by making use of the DC component (LA0) of the electric signal or the phase component at the frequency twice the Larmor frequency of the electric signal, as the first component of the electric signal wherein the excitation source (8) comprises a third coil with an axis orthogonal to the axes of the first and second coils, and wherein the vectorial measurement of the ambient magnetic field comprises feeding each of the coils with a current having a predetermined frequency specific to this coil, synchronously demodulating the electric signal at each of the predetermined frequencies and determining the components of the ambient magnetic field along the axes of the coils.

**4.** The method according to one of claims 1 and 2, wherein the excitation source (8) comprises a first and a second coil with orthogonal axes surrounding the cell and fed by a radiofrequency generator to generate a radiofrequency magnetic field therein, wherein the first control system (AS1) is configured to control the frequency of the radiofrequency generator to the Larmor frequency of the gas filling the cell by making use of the DC component (LA0) of the electric signal or the phase component at the frequency twice the Larmor frequency of the electric signal, as the first component of the electric signal, wherein the measurement of the vectorial field is not made by the scalar magnetometer.

5. The method according to one of claims 3 and 4, comprising driving the orientation of the radiofrequency magnetic field in the plane orthogonal to the direction of propagation of the laser beam from said theoretical rotation angle.

6. The method according to one of claims 3 and 4, wherein the polarisation rotator (3) comprises a polariser rotatably motorised by a motor also driving the orientation of the radiofrequency magnetic field in the plane orthogonal to the direction of propagation of the laser beam.

7. The method according to one of claims 2 to 6, comprising comparing said theoretical rotation angle with a value of rotation angle provided by a driving law of the polarisation rotator associating values of polarisation orientation set point with values of rotation angle, and correcting the driving law as a function of the result of the comparison.

8. A system for measuring a magnetic field, comprising a scalar magnetometer which comprises:

   - an optical pumping source (1) able to emit a laser beam towards a cell (4) filled with a gas along a direction of propagation,
   - a polarisation rotator (3) able to rotate the direction of polarisation of the laser beam by being driven by a polarisation orientation set point,
   - a magnetic resonance excitation source (8),
   - a photodetector (5) receiving the laser beam that passed through the cell and providing an electric signal,
   - a first control system (AS1) configured to make a frequency control of the magnetic resonance excitation source from a first component (LA0) of the electric signal,

   the system being **characterised in that** it includes a controller (CAL) configured to:

   - calculate, from a vectorial measurement of the ambient magnetic field, an alignment deviation ($\alpha_{\vec{B},\vec{k}}$) of the ambient magnetic field relative to the direction of propagation of the laser beam, and a theoretical rotation angle ($\theta_{pol\,theo}$) to be supplied to the polarisation of the pump laser beam in a plane orthogonal to the direction of propagation of the laser beam such that the polarisation of the laser beam is orthogonal to the ambient magnetic field, and
   - when the alignment deviation is lower than a threshold, using as a polarisation orientation set point, the value of said theoretical rotation angle or the current value of said set point when it has been detected that the alignment deviation is lower than the threshold.

9. The system according to claim 8, wherein the scalar magnetometer comprises a second control system (AS2) configured to provide to the polarisation rotator (3), from a second component (LA1Q) of the electric signal, a command signal for maintaining the direction of polarisation of the laser beam orthogonal to the ambient magnetic field, and wherein the controller is further configured to inhibit the second control system when the alignment deviation is lower than the threshold.

10. The system according to one of claims 8 and 9, wherein the excitation source (8) comprises a first and a second coil with orthogonal axes surrounding the cell and fed by a radiofrequency generator to generate a radiofrequency magnetic field therein, and wherein the first control system (AS1) is configured to control the frequency of the radiofrequency generator to the Larmor frequency of the gas filling the cell by making use, as the first component of the electric signal, of the DC component (LA0) of the electric signal or the phase component at the frequency twice the Larmor frequency (LA2) of the electric signal.

11. The system according to one of claims 8 and 9, wherein the excitation source (8) comprises a modulator of the laser beam controlled by the first control system (AS1).

12. The system according to one of claims 8 to 11, wherein the polarisation rotator (3) is a liquid crystal polarisation rotator.

FIG.1

FIG.2

FIG.3

EP 3 370 077 B1

FIG.4

z

x

$y // \vec{k}$

7

6

1

2

3

4

5

8

AS2

AS1

INJ

D0

D1Q

MBV

CAL

$\theta_{pol\ theo}\ ;\ \alpha_{\vec{B},\vec{k}}$

## RÉFÉRENCES CITÉES DANS LA DESCRIPTION

**Documents brevets cités dans la description**

- EP 2795354 B1

- EP 1344075 B1

**Littérature non-brevet citée dans la description**

- **T. WU et al.** A dead-zone free He atomic magnetometer with intensity-modulated linearly polarized light and a liquid crystal polarization rotator. *Review of Scientific Instruments,* 2015, vol. 86, 10